# EUROPÄISCHE PATENTSCHRIFT

(11) **EP 1 058 293 B1**
(45) Veröffentlichungstag und Bekanntmachung des Hinweises auf die Patenterteilung: **31.10.2007**
(21) Anmeldenummer: 00111147.5
(22) Anmeldetag: 24.05.2000
(51) Int. Cl.: H01L 21/00

(54) **Verfahren und Vorrichtung zum Trocknen von scheibenförmigen Gegenständen**
Process and apparatus for drying wafer-like objects
Procédé et dispositif pour le séchage d'articles en forme de plaquettes

(30) Priorität: 04.06.1999 AT 100299
(43) Veröffentlichungstag der Anmeldung: 06.12.2000
(73) Patentinhaber: SEZ AG, 9500 Villach (AT)
(72) Erfinder: Kruwinus, Hans-Jürgen, Dipl.-Ing., 9557 Bodensdorf (AT)

(56) Entgegenhaltungen:
- EP-A- 0 793 259
- US-A- 5 226 242
- US-A- 5 271 774

## Beschreibung

Die Erfindung betrifft ein Verfahren und eine Vorrichtungen zum Herstellen eines Trocknungsgases zum Trocknen und das Trocknen von scheibenförmigen Gegenständen, insbesondere von Halbleitersubstraten, wie Siliziumwafer, Galliumarsenidwafer, aber auch von Glas- und Quarzsubstraten, Metallsubstraten, Flachbildschirmen (Flat Panel Display) und Compactdiscs.

Besonders im Vordergrund steht bei der Erfindung das Trocknen von Halbleiterscheiben (Wafer), wie Siliziumwafer bzw. Halbleiterscheiben (Wafer) auf Basis von Galliumarsenid.

Beim Trocknen von Siliziumwafern ist es besonders nachteilig, dass während des Trockenverfahrens eine für den Halbleiterwafer nachteilige Partikelzunahme auftritt, also nicht rückstandsfrei getrocknet werden kann.

Ursache für die erwähnte, nachteilige Partikelbildung ist bei Siliziumwafern, dass Wasser mit Silizium bei Anwesenheit von Sauerstoff (z.B. aus der Luft) zu Siliziumdioxid reagiert. Diese Partikel werden auch Wasserflecke (Watermarks) genannt.

Die US 5,271,774 A und die EP 0 905 746 A1 beschreiben jeweils ein Verfahren zum Entfernen von Flüssigkeiten von einer Oberfläche eines scheibenförmigen Gegenstandes. In beiden Schriften erfolgt das Trocknen von scheibenförmigen Gegenständen durch Aufblasen eines Trocknungsgases auf die Oberfläche des scheibenförmigen Gegenstandes. Das Trocknungsgas enthält ein Trägergas und eine Wirksubstanz und der scheibenförmige Gegenstand rotiert während des Aufblasens des Trocknungsgases um seine Achse.

In der US 5,271,774 A wird ein Verfahren zur Aufbereitung eines entsprechenden Trocknungsgases beschrieben bei dem das Trägergas durch die vorgelegt flüssige Wirksubstanz geblubbert wird.

Die JP 09-162156 A beschreibt eine Vorrichtung zur Reinigen und Trockenen von Halbleiter-Wafern mit einem Trocknungsgas, das durch Erhitzen eines Lösungsmittels hergestellt wird.

Die EP 0878832 A2 beschreibt eine Verfahren und eine Vorrichtung zum Trocknen von Halbleiter-Wafern mit einem Trocknungsgas, das durch Mischen eines Trägergases mit einer Flüssigkeit hergestellt wird. Das Mischen erfolgt hier mit einer Düse.

Der Erfindung liegt die Aufgabe zugrunde, Flüssigkeitsreste, insbesondere Reste von deionisiertem Wasser, die sich von vorhergegangenen Behandlungsschritten auf der Oberfläche des scheibenförmigen Gegenstandes, insbesondere des Siliziumwafers, befinden können, möglichst rasch zu entfernen, so dass die erwähnte Partikelbildung nicht oder nicht in störendem Ausmaß auftritt.

Danach schlägt die Erfindung in ihrer allgemeinsten Ausführungsform ein Verfahren zum Herstellen eines Trocknungsgases zum Trocknen eines oder mehrerer scheibenförmiger Gegenstände, bei dem ein Trägergas und eine Wirksubstanz gemischt werden. Das Trocknungsgas wird hergestellt, indem das Trägergas mit dem ruhenden Flüssigkeitsspiegel der Wirksubstanz in Kontakt tritt. Dabei reichert sich das Trägergas zum Teil mit über der Flüssigkeit befindlichen Gas der Wirksubstanz an.

Dies hat den Vorteil, dass sich im Trocknungsgas keine Flüssigkeitströpfchen der Wirksubstanz und daher auch kein Nebel befinden kann - dies verbessert die Gleichmäßigkeit der Trocknung.

Durch die Mischung von einem Trägergas mit einer Wirksubstanz kann eine Konzentration gewählt werden, bei der, selbst wenn die Wirksubstanz bei der Anwendungstemperatur mit Luft brennbare oder zündfähige Gemische bilden kann, keine brennbaren oder zündfähigen Gemische entstehen können.

Wird der Partialdruck des Trägergases bei in Kontakt Treten mit der flüssigen Wirksubstanz über dem Normaldruck gewählt, so verringert sich bei gleichbleibendem Partialdruck der Wirksubstanz der Anteil der Wirksubstanz im Trocknungsgas. Bei dieser Ausführungsform wird das Trocknungsgas, bevor es mit der Oberfläche des scheibenförmigen Gegenstandes in Kontakt gebracht wird, entspannt. Ein vorteilhafter Partialdruck des Trägergases bei in Kontakt Treten mit der flüssigen Wirksubstanz liegt im Bereich von 1,5 - 7 bar (z.B. 3 - 4 bar).

In einer Ausführungsform der Erfindung ist der Partialdruck der Wirksubstanz im Trocknungsgas weniger als 20 % des Sättigungsdampfdruckes, da dadurch der Verbrauch an Wirksubstanz gering gehalten wird und eine höhere Konzentration den Effekt kaum verbessert.

Auch bei einem Partialdruck der Wirksubstanz im Trocknungsgas von weniger als 5 % des Sättigungsdampfdruckes konnten gute Ergebnisse erzielt werden. Ein derart niedriger Partialdruck hat den Vorteil, dass bei brennbaren Wirksubstanzen, wenn als Tägergas ein Inertgas gewählt wird, sich keine zündfähigen Gasgemische bilden können.

Bei einer Ausführungsform ist der Partialdruck der Wirksubstanz im Trocknungsgas 0,01 - 10 hPa (bei einem Gesamtdruck von 1000 hPa); dies entspricht einer Konzentration zwischen 0,001 und 1 vol%. Dies ist schon allein aus Umweltgründen, aber auch aus wirtschaftlichen und sicherheitstechnischen Gründen von Vorteil.

Wenn die Wirksubstanz, im Trocknungsgas so gewählt wird, dass die Flüssigkeit die Oberfläche des Gegenstandes besser benetzt, können eventuell auf der Oberfläche haftende Tröpfchen verrinnen, da sie das Bestreben bekommen, eine möglichst große gemeinsame Grenzfläche mit der Oberfläche des scheibenförmigen Gegenstandes zu bilden.

Die im Verfahren verwendete Wirksubstanz kann, um den gewünschten Effekt zu erzielen, so gewählt werden, dass sie die Oberflächenspannung der Flüssigkeit, von der der scheibenförmige Gegenstand zu trocknen ist, verringert.

Hierunter sollen nicht nur oberflächenaktive Substanzen im klassischen Sinne (Netzmittel bzw. Tenside) verstanden werden. Auch andere organische oder anorganische Substanzen, die wesentlich kürzere Ketten aufweisen, können verwendet werden. Allen diesen Substanzen ist gemein, dass ihr Molekül einen polaren (hydrophilen bzw. lipophoben) Teil und eine apolaren (hydrophoben bzw. lipophilen) besitzt.

Auf diese Art wird es polaren Lösungsmitteln (z.B. Wasser) möglich, apolare (hydrophobe) Oberflächen (z.B. elementares Silizium) zu benetzen. Umgekehrt können apolare Lösungsmittel (z.B. Petrolether) polare Oberflächen (Siliziumdioxid) benetzen.

Eine vorteilhafte Wirksubstanz stellt ein organisches Lösungsmittel dar.

Als gut geeignete Wirksubstanzen zeigten sich Flüssigkeiten, die einen Sättigungsdampfdruck bei Raumtemperatur (25°C) 0,5 - 200 hPa besitzen. Dadurch kann der Partialdruck der Wirksubstanz im Trocknungsgas mittels Verdampfen der Flüssigkeit hergestellt werden.

Soll der scheibenförmige Gegenstand von Wasser getrocknet werden, so ist es vorteilhaft wenn die Wirksubstanz eine Löslichkeit in Wasser von zumindest 1 g/l besitzt, damit sie ihren Einfluß auf das Benetzungsverhalten des Wassers nehmen kann.

Eine Löslichkeit in Wasser von zumindest 10 g/l hat sich als vorteilhaft erwiesen.

Die Wirksubstanz kann aus der Gruppe Silanole (z.B. Triethylsilanol, Trimethylsilanol), Alkohole (z.B. Ethanol, Propanol), Ester (z.B. Ethylacetat), Ketone (z.B. Aceton), Aldehyde und Amide (z.B. Dimethylformamid DMF) gewählt werden.

Eine vorteilhafte Wirksubstanz ist ein Alkohol, wobei längerkettige Alkohole (n-Hexanol) den Vorteil haben, die Benetzung stärker zu verbessern und kürzerkettige (Ethanol) leichter von der Oberfläche desorbieren. Gut geeignet ist 2-Propanol, weil es die beiden Vorteile in sich vereint.

Selbstverständlich können auch beliebige Gemische der Wirksubstanzen verwendet werden.

Das Trägergas des Trocknungsgases kann ein Inertgas wie z.B. Stickstoff sein. Durch die Mischung des Wirkstoffes mit einem Inertgas kann verhindert werden, dass sich mit der Umgebungsluft brennbare oder zündfähige Gemische bilden.

Ein weiterer Teil der Erfindung ist ein Verfahren zum Trocknen von scheibenförmigen Gegenständen durch Beblasen der Oberfläche des scheibenförmigen Gegenstandes mit einem nach einem der oben beschriebenen Verfahren hergestellten Trocknungsgas. Der scheibenförmige Gegenstand rotiert während des Beblasens mit dem Trocknungsgas um seine Achse.

Die Rotation des scheibenförmigen Gegenstandes ist einerseits vorteilhaft, um die Oberfläche möglichst gleichmäßig mit dem Trocknungsgas zu behandeln und gleichzeitig den Verbrauch an Trocknungsgas so gering wie möglich halten zu können. Andererseits wird durch eine hohe Schergeschwindigkeit und damit verbunden eine kleine Diffusionsschicht in der Gasphase die Verdunstungsgeschwindigkeit stark erhöht.

In einer Ausführungsform beträgt der Volumenstrom des Trocknungsgases beim Beblasen der Oberfläche des scheibenförmigen Gegenstandes 10 - 100 l/min, wobei der Volumenstrom bei Normaldruck (1000 hPa) gemessen wird. Dies führt zu einer hohen Strömungsgeschwindigkeit unmittelbar auf der Oberfläche und damit zu einer schnelleren Trocknung.

Die Behandlungszeit des scheibenförmigen Gegenstandes mit dem Trocknungsgas beträgt bei einer Ausführungsform des Verfahren 3 - 30 s. Eine derartige Behandlungszeit ist vorteilhaft in Hinblick auf Trocknungsergebnis und Wirtschaftlichkeit.

Vorteilhafterweise wird die Rotationsgeschwindigkeit in einem Bereich von 100 bis 10.000 Umdrehungen pro Minute gewählt. Gute Ergebnisse erzielt man im Bereich von 500 bis 3.000 Umdrehungen pro Minute.

Bei einer Ausführungsform des erfindungsgemäßen Verfahrens erfolgt das Beblasen mit Trocknungsgas beginnend im Zentrum der Oberfläche des scheibenförmigen Gegenstandes während des Rotierens des scheibenförmigen Gegenstandes sukzessive bis zum umfangseitigen Rand des scheibenförmigen Gegenstandes.

Dadurch wird erreicht, dass eventuell abrinnende Flüssigkeitstropfen nicht über bereits getrocknete Bereiche der Oberfläche rinnen.

Beispielsweise wird das Trocknungsgas bereichsweise (punktuell) auf den scheibenförmigen Gegenstand aufgebracht, und es werden in zeitlicher Abfolge alle Bereiche der Oberfläche des scheibenförmigen Gegenstandes erreicht.

Das Trocknungs-Verfahren kann Teil eines Verfahren zum Behandeln von scheibenförmigen Gegenständen mit Flüssigkeiten sein, bei dem die letzte Flüssigkeit eine Spülflüssigkeit (z.B. entionisiertes Wasser) ist und diese durch eines der vorbeschriebenen Trocknungs-Verfahren von der Oberfläche des scheibenförmigen Gegenstandes entfernt wird.

Bei diesem Verfahren kann es sich um ein Reinigungsverfahren, ein Ätzverfahren, ein Verfahren zum Entwickeln oder Entfernen von Photolacken oder auch eine Kombination dieser Verfahren handeln. Wesentlich ist es, dass die letzte Behandlungsflüssigkeit (Reinigungslösung bzw. Ätzlösung) durch eine Spülflüssigkeit verdrängt wird. Der Trocknungsschritt kann unmittelbar auf den Spülschritt folgen, oder es kann der Großteil der Spülflüssigkeit vor Beginn des Trocknungsschrittes abgeschleudert werden.

In einer Ausführungsform dieses Verfahrens rotiert der scheibenförmige Gegenstand während aller Flüssigkeitsbehandlungsschritte um seine Achse.

Ein weiterer Teil der Erfindung ist eine Einrichtung zur Herstellung eines Trocknungsgases, die geeignet ist, ein Trägergas und eine Wirksubstanz miteinander zu mischen. Diese Einrichtung besteht zur Herstellung des Trocknungsgases aus einem Behälter 1 mit einem ersten unteren Bereich 2 zur Aufnahme der Wirksubstanz 3 und einem zweiten oberen Bereich 4. Eine Öffnung 5 des Behälters 1 ist über eine erste Leitung 6 mit einer Gasquelle 7 des Trägergases und eine weitere Öffnung 8 über eine zweite Leitung 9 mit dem Ort 10, an dem das Trocknungsgas mit der Oberfläche des (der) scheibenförmigen Gegenstandes 11 in Kontakt tritt, verbunden. Beide Öffnungen 5 und 8 befinden sich im zweiten oberen Bereich 4 des Behälters 1.

Dadurch wird ermöglicht, dass das Trocknungsgas unmittelbar bevor es zur Anwendung kommt gemischt wird und es wird verhindert, dass nicht gasförmige Teile der Wirksubstanz 3 im Trocknungsgas mitgerissen werden. Außerdem kann der Verbrauch an Wirksubstanz 3 gering gehalten werden, da nur bereits verdampfte Wirksubstanz 3 sich im Trocknungsgas anreichern kann.

Die Gasquelle 7 des Trägergases kann eine Druckgasleitung oder eine unter Druck stehende Gasflasche sein. Zwischen der Gasquelle und der Einrichtung zur Herstellung des Trocknungsgases kann der Druck des Trägergases durch ein Reduzierventil 15 reduziert werden.

Bei einer weiteren Ausführungsform der Vorrichtung befindet sich in der Leitung 9 zwischen Einrichtung zur Herstellung des Trocknungsgases und dem Ort 10, an dem das Trocknungsgas mit der Oberfläche des scheibenförmigen Gegenstandes 11 in Kontakt tritt, ein Reduzierventil 12. Dadurch ergibt sich, dass in der Einrichtung ein Überdruck herrscht, wodurch die Wirkstoff-Konzentration an der Düse 14 geringer wird.

Um die Herstellung des Trocknungsgases zu vergleichmäßigen, kann die Einrichtung temperiert (Heizung 16) werden. Dies kann z.B. dann sinnvoll sein, wenn die Temperaturen des Trägergases und der Wirksubstanz 3 vor ihrem Zusammenführen variieren können.

Ein weiterer Teil der Erfindung ist eine Vorrichtung zum Trocknen von scheibenförmigen Gegenständen mit einem rotierbaren Träger 13 zur Aufnahme eines scheibenförmigen Gegenstandes 11 und mit einer Düse 14 zum Beblasen der Oberfläche des scheibenförmigen Gegenstandes 11 mit Trocknungsgas. Die Düse 14 ist mit einer Einrichtung zur Herstellung des Trocknungsgases über eine Leitung 9 verbunden.

Die Düse 14 ist mit ihrer Mündung auf die Oberfläche des scheibenförmigen Gegenstandes 11 gerichtet, und zwar in einem Winkel von 20° bis 90°.

In einer Ausführungsform der Vorrichtung kann die Düse 14 im Abstand zur Oberfläche des scheibenförmigen Gegenstandes 11 und parallel zu dieser Oberfläche bewegt werden, wodurch das Trocknungsgas bei Rotation des scheibenförmigen Gegenstandes auf jeden Bereich von dessen Oberfläche geblasen werden kann. Außerdem ist dies sinnvoll, damit die Düse 14 für andere Behandlungsschritte und während des Be- und Entladens des Trägers 13 mit dem scheibenförmigen Gegenstand 11 entfernt werden kann.

Der Abstand der Mündung der Düse 14 zur Oberfläche des scheibenförmigen Gegenstandes 11 kann dabei 2 - 50 mm betragen.

Weitere Einzelheiten, Merkmale und Vorteile der Erfindung ergeben sich aus der nachstehenden Beschreibung der Ausführungsbeispiele der Erfindung.

Bei Beispiel 1 wird nach einer Reinigung mit Wasserstoffperoxid und Ammoniak die Oberfläche eines Siliziumwafers, auf der sich die Strukturen befinden, mit entionisiertem Wasser gespült, während der Wafer mit 500 Umdrehungen pro Minute rotiert. Anschließend erfolgt ein Abschleudern der Spülflüssigkeit bei 2.000 Umdrehungen pro Minute. Bei einer Rotationsgeschwindigkeit von 1.000 wird nun die Waferoberfläche mit einem Trocknungsgas 10 s lang abgeblasen. Das Trocknungsgas wird dabei mit einer Düse aufgebracht, die parallel und im Abstand (5 mm) zur Waferoberfläche über diese bewegt wird. Die Düse bewegt sich vom Zentrum des Wafers (zugleich Rotationszentrum) mit gleichbleibender Geschwindigkeit während der 10 s zum umfangseitigen Rand des Wafers.

Als Wirksubstanz im Trocknungsgas wird 2-Propanol mit einem Partialdruck im Trocknungsgas von 0,1 hPa verwendet, das Trägergas ist Stickstoff. Die Strömungsgeschwindigkeit des Trocknungsgases beträgt 60 l/min.

Das Trocknungsgas wird in einem Behälter hergestellt, in dem das 2-Propanol mit einer Temperatur von 20°C vorgelegt worden ist. Der Behälter ist etwa zur Hälfte gefüllt. Stickstoff strömt über eine Öffnung im Deckel des Behälters ein, das Trocknungsgas entweicht über eine weitere Öffnung im Deckel des Behälters. Der Stickstoff streicht mit einem Partialdruck von 6 bar über den ruhenden Flüssigkeitsspiegel. Der Partialdruck des 2-Propanol beträgt während des Betriebes 0,6 hPa (das sind ca. 1,3 % des Sättigungsdampfdrucks von 45 hPa). Das unter Druck stehende Trocknungsgas hat einen Gesamtdruck von demnach 6000,6 hPa, wodurch sich nach Entspannen des Trocknungsgases auf Normaldruck (1000 hPa) der Partialdruck von 0,1 hPa an der Düse ergibt.

Beispiel 2 geht von Beispiel 1 aus, jedoch erfolgt die Trocknung anschließend an einen Rückseiten-Ätzprozeß, bei dem eine Siliziumdioxid-Schicht entfernt worden ist. Die Trocknung erfolgt unmittelbar nach dem Spülen mit entionisiertem Wasser ohne Abschleudern als Zwischenschritt, d.h. die Wasserreste werden direkt mit dem 5 s langen Aufblasen des Trocknungsgases entfernt, bei einer Rotationsgeschwindigkeit von 1500 Umdrehungen pro Minute.

Als Wirksubstanz im Trocknungsgas wird 2-Propanol mit einem Partialdruck im Trocknungsgas von 0,4 hPa verwendet, das Trägergas ist Stickstoff. Die Strömungsgeschwindigkeit des Trocknungsgases beträgt 80 l/min.

Das 2-Propanol ist mit einer Temperatur von 30°C vorgelegt worden. Der Stickstoff streicht mit einem Partialdruck von 2 bar über den ruhenden Flüssigkeitsspiegel. Der Partialdruck des 2-Propanols beträgt während des Betriebes 0,8 hPa (das sind ca. 1 % des Sättigungsdampfdrucks von 83 hPa). Das unter Druck stehende Trocknungsgas hat einen Gesamtdruck von demnach 2000,8 hPa, wodurch sich nach Entspannen des Trocknungsgases auf Normaldruck (1000 hPa) der Partialdruck von 0,4 hPa an der Düse ergibt.

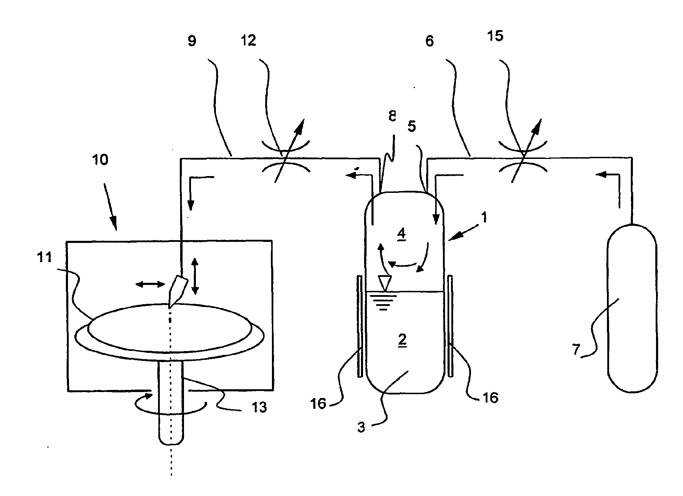

## Patentansprüche

1. Verfahren zum Herstellen eines Trocknungsgases zum Trocknen eines oder mehrerer scheibenförmiger Gegenstände, bei dem ein Trägergas und eine Wirksubstanz gemischt werden **dadurch gekennzeichnet, dass** das Trägergas mit dem ruhenden Flüssigkeitsspiegel der Wirksubstanz in Kontakt tritt und sich dabei zum Teil mit dem über der Flüssigkeit befindlichem Gas der Wirksubstanz anreichert.

2. Verfahren nach Anspruch 1 **dadurch gekennzeichnet, dass** der Partialdruck des Trägergases bei in Kontakt Treten mit der flüssigen Wirksubstanz über Normaldruck ist und das Trocknungsgas, bevor es mit der Oberfläche des scheibenförmigen Gegenstandes (11) in Kontakt gebracht wird, entspannt, wird.

3. Verfahren nach einem der Ansprüche 1 oder 2 **dadurch gekennzeichnet, dass** der Partialdruck der Wirksubstanz im Trocknungsgas weniger als 20 % des Sättigungsdampfdruckes ist.

4. Verfahren nach Anspruch 3 **dadurch gekennzeichnet, dass** der Partialdruck der Wirksubstanz im Trocknungsgas weniger als 5 % des Sättigungsdampfdruckes ist.

5. Verfahren nach einem der Ansprüche 1 bis 4 **dadurch gekennzeichnet, dass** der Partialdruck der Wirksubstanz im Trocknungsgas 0,01 - 10 hPa ist (bei einem Gesamtdruck von 1000 hPa).

6. Verfahren nach einem der Ansprüche 1 bis 5 **dadurch gekennzeichnet, dass** die Wirksubstanz die Flüssigkeit, von der der scheibenförmige Gegenstand zu trocknen ist, derart beeinflußt, dass die Flüssigkeit die Oberfläche des zu trocknenden scheibenförmigen Gegenstandes besser benetzt.

7. Verfahren nach einem der Ansprüche 1 bis 6 **dadurch gekennzeichnet, dass** die Wirksubstanz ein organisches Lösungsmittel ist.

8. Verfahren nach einem der Ansprüche 1 bis 7 **dadurch gekennzeichnet, dass** die Wirksubstanz eine Flüssigkeit ist, die einen Sättigungsdampfdruck bei Raumtemperatur (25°C) von 0,5 - 200 hPa besitzt.

9. Verfahren nach Anspruch 1 bis 8 **dadurch gekennzeichnet, dass** das Trägergas ein Inertgas ist.

10. Verfahren zum Trocknen von scheibenförmigen Gegenständen durch Beblasen der Oberfläche des scheibenförmigen Gegenstandes (11) mit einem nach einem der Ansprüche 1 - 9 hergestellten Trocknungsgas **dadurch gekennzeichnet, dass** der scheibenförmige Gegenstand (11) während des Beblasens mit dem Trocknungsgas um seine Achse rotiert.

11. Verfahren nach Anspruch 10 **dadurch gekennzeichnet, dass** beim Beblasen der Oberfläche des scheibenförmigen Gegenstandes der Volumenstrom des Trocknungsgases 10 - 100 l/min beträgt.

12. Verfahren nach einem der Ansprüche 10 oder 11 **dadurch gekennzeichnet, dass** die Behandlungszeit des scheibenförmigen Gegenstandes mit dem Trocknungsgas 3 - 30 s beträgt.

13. Verfahren nach einem der Ansprüche 10 bis 12 **dadurch gekennzeichnet, dass** die Rotationsgeschwindigkeit in einem Bereich von 100 bis 10.000 Umdrehungen pro Minute gewählt wird.

14. Einrichtung zur Herstellung des Trocknungsgases zum Trocknen eines oder mehrerer scheibenförmiger Gegenstände, die geeignet ist ein Trägergas und eine Wirksubstanz zu mischen **dadurch gekennzeichnet, dass** die Einrichtung aus einem Behälter besteht mit einem ersten unteren Bereich zur Aufnahme der Wirksubstanz (3) in flüssiger Form und einem zweiten oberen Bereich (4), und dass eine Öffnung (5) des Behälters (1) über eine erste Leitung mit einer Gasquelle (7) des Trägergases und eine weitere Öffnung (8) über eine zweite Leitung (9) mit dem Ort (10), an dem das Trocknungsgas mit der Oberfläche des scheibenförmigen Gegenstandes (11) in Kontakt tritt, verbunden ist, und dass- die beiden Öffnungen sich im zweiten oberen Bereich (4) des Behälters (1) befinden.

15. Einrichtung nach Anspruch 14 **dadurch gekennzeichnet, dass** sich in der Leitung zwischen dem Behälter (1) und dem Ort (10), an dem das Trocknungsgas mit der Oberfläche des scheibenförmigen Gegenstandes (11) in Kontakt tritt, ein Reduzierventil (12) befindet.

16. Vorrichtung zum Trocknen von scheibenförmigen Gegenständen mit einem rotierbaren Träger (13) zur Aufnahme eines scheibenförmigen Gegenstandes (11), mit einer Düse (14) zum Beblasen der Oberfläche des scheibenförmigen Gegenstandes (11) mit Trocknungsgas, bei der die Düse (14) mit einer Einrichtung nach einem der Ansprüche 14 oder 15 zur Herstellung des Trocknungsgases über eine Leitung verbunden ist.

17. Vorrichtung nach Anspruch 16 **dadurch gekennzeichnet, dass** Mittel vorgesehen sind, die die Düse (14) im Abstand zur Oberfläche des scheibenförmigen Gegenstandes (11) und parallel zu dieser Oberfläche bewegen können.

## Claims

1. Method for producing a drying gas for drying one or more disc-shaped objects, in which a carrier gas and an active substance are mixed, **characterised in that** the carrier gas comes into contact with the static liquid level of the active substance and is thereby enriched in part with the gas of the active substance which is situated above the liquid.

2. Method according to claim 1, **characterised in that** the partial pressure of the carrier gas, when coming into contact with the liquid active substance, is above normal pressure, and the drying gas, before it is brought into contact with the surface of the disc-shaped object (11), has the pressure released.

3. Method according to one of the claims 1 or 2, **characterised in that** the partial pressure of the active substance in the drying gas is less than 20% of the saturation vapour pressure.

4. Method according to claim 3, **characterised in that** the partial pressure of the active substance in the drying gas is less than 5% of the saturation vapour pressure.

5. Method according to one of the claims 1 to 4, **characterised in that** the partial pressure of the active substance in the drying gas is less than 0.01 - 10 hPa (at a total pressure of 1000 hPa).

6. Method according to one of the claims 1 to 5, **characterised in that** the active substance influences the liquid, of which the disc-shaped object is to be dried, in such a manner that the liquid has a better wetting effect on the surface of the disc-shaped object which is to be dried.

7. Method according to one of the claims 1 to 6, **characterised in that** the active substance is an organic solvent.

8. Method according to one of the claims 1 to 7, **characterised in that** the active substance is a liquid which has a saturation vapour pressure at room temperature (25°C) of 0.5 - 200 hPa.

9. Method according to claim 1 to 8, **characterised in that** the carrier gas is an inert gas.

10. Method for drying disc-shaped objects by blowing upon the surface of the disc-shaped object (11) with a drying gas which is produced according to one of the claims 1 - 9, **characterised in that** the disc-shaped object (11) rotates about the axis thereof whilst being blown upon with the drying gas.

11. Method according to claim 10, **characterised in that**, whilst the surface of the disc-shaped object is being blown upon, the volume flow of the drying gas is 10 - 100 l/min.

12. Method according to one of the claims 10 or 11, **characterised in that** the treatment time of the disc-shaped object with the drying gas is 3 - 30 s.

13. Method according to one of the claims 10 to 12, **characterised in that** the speed of rotation is chosen in a range of 100 to 10,000 rpm.

14. Device for producing the drying gas for drying one or more disc-shaped objects, which is suitable for mixing a carrier gas and an active substance, **characterised in that** the device comprises a container having a first lower region for receiving the active substance (3) in liquid form and a second upper region (4), and **in that** an opening (5) of the container (1) is connected via a first line to a gas source (7) of the carrier gas and a further opening (8) via a second line (9) to the position (10) at which the drying gas comes into contact with the surface of the disc-shaped object (11), and **in that** the two openings are located in the second upper region (4) of the container (1).

15. Device according to claim 14, **characterised in that** a reducing valve (12) is located in the line between the container (1) and the position (10) at which the drying gas comes into contact with the surface of the disc-shaped object (11).

16. Device for drying disc-shaped objects having a rotatable carrier (13) for receiving a disc-shaped object (11), having a nozzle (14) for blowing upon the surface of the disc-shaped object (11) with drying gas, in which the nozzle (14) is connected via a line to a device according to one of the claims 14 or 15 for producing the drying gas.

17. Device according to claim 16, **characterised in that** means are provided which can move the nozzle (14) at a spacing from the surface of the disc-shaped object (11) and parallel to this surface.

## Revendications

1. Procédé de fabrication d'un gaz destiné au séchage d'un ou plusieurs articles en forme de plaquette, obtenu par mélange d'un gaz porteur et d'une substance active, **caractérisé en ce que** le gaz porteur est amené en contact avec la surface au repos de la substance active à l'état liquide pour s'enrichir ainsi partiellement en gaz de la substance active qui se trouve au-dessus du liquide.

2. Procédé selon la revendication 1, **caractérisé en ce que** la pression partielle de gaz porteur, venant en contact avec la substance active liquide, dépasse la pression normale et le gaz de séchage est détendu avant de venir en contact avec la surface de l'article en forme de plaquette.

3. Procédé selon la revendication 1 ou 2, **caractérisé en ce que** la pression partielle de la substance active dans le gaz de séchage est inférieure à 20 % de la pression de vapeur saturante.

4. Procédé selon la revendication 3, **caractérisé en ce que** la pression partielle de la substance active dans le gaz de séchage est inférieure à 5 % de la pression de vapeur saturante.

5. Procédé selon une des revendications 1 à 4, **caractérisé en ce que** la pression partielle de la substance active dans le gaz de séchage est de 0,01 à 10 hPa (pour une pression totale de 1000 hPa).

6. Procédé selon une des revendications 1 à 5, **caractérisé en ce que** la substance active influence le liquide qu'il s'agit de sécher sur l'article en forme de plaquette, en améliorant le mouillage de la surface à sécher.

7. Procédé selon une des revendications 1 à 6, **caractérisé en ce que** la substance active est un solvant organique.

8. Procédé selon une des revendications 1 à 7, **caractérisé en ce que** la substance active est un liquide dont la pression de vapeur saturante à la température ambiante (25° C) est de 0,5 à 200 hPa.

9. Procédé selon une des revendications 1 à 8, **caractérisé en ce que** le gaz porteur est un gaz inerte.

10. Procédé de séchage d'articles en forme de plaquettes par soufflage sur la surface d'un tel article (11), d'un gaz de séchage produit selon une des revendications 1 à 9, **caractérisé en ce que** l'article en forme de plaquette (11) tourne autour de son axe pendant que le gaz de séchage est soufflé sur lui.

11. Procédé selon la revendication 10, **caractérisé en ce que** le débit volumique du gaz de séchage soufflé sur la surface de l'article en forme de plaquette est de 10 à 100 l/minute.

12. Procédé selon la revendication 10 ou 11, **caractérisé en ce que** le temps de traitement de l'article en forme de plaquette est de 3 à 30 secondes.

13. Procédé selon une des revendications 10 à 12, **caractérisé en ce que** la vitesse de rotation est choisie dans une plage de 100 à 10 000 tours par minute.

14. Dispositif de fabrication du gaz de séchage d'un ou plusieurs articles en forme de plaquettes, qui est apte à mélanger un gaz porteur et une substance active, **caractérisé en ce que** ce dispositif est composé d'un récipient avec une première zone inférieure pour accueillir la substance active (3) sous forme liquide et une seconde zone supérieure (4), une ouverture (5) du récipient (1) étant reliée par une première conduite à une source (7) de gaz porteur tandis qu'une seconde ouverture (8) est reliée par une seconde conduite (9) à l'endroit (10) où le gaz de séchage entre en contact avec la surface de l'article (11) en forme de plaquette, les deux ouvertures se trouvant dans la seconde partie supérieure (4) du récipient (1).

15. Dispositif de fabrication selon la revendication 14, **caractérisé en ce qu'**une soupape de réduction (12) est montée dans la conduite reliant le récipient (1) au lieu (10) où le gaz de séchage vient en contact avec la surface de l'article (11) en forme de plaquette.

16. Dispositif pour sécher des articles en forme de plaquettes, qui comporte un support (13) pour accueillir un article (11) en forme de plaquette, une buse (14) pour souffler des gaz de séchage sur la surface de l'article (11), la buse (14) étant reliée à un dispositif de fabrication de gaz de séchage selon une des revendications 14 ou 15.

17. Dispositif selon la revendication 16, **caractérisé en ce que** sont prévus des moyens permettant de déplacer la buse parallèlement à la surface de l'article (11) en forme de plaquette et à une certaine distance de cette surface.
